# EUROPÄISCHE PATENTSCHRIFT

(11) **EP 3 966 734 B1**
(45) Veröffentlichungstag und Bekanntmachung des Hinweises auf die Patenterteilung: **25.11.2026**
(21) Anmeldenummer: 20739866.0
(22) Anmeldetag: 22.06.2020
(51) Int. Cl.: G06V 20/10, G06T 7/00

(54) **VERFAHREN ZUR ERMITTLUNG UND DARSTELLUNG VON POTENZIELLEN SCHADSTELLEN AN KOMPONENTEN VON FREILEITUNGEN**
METHOD FOR DETERMINING AND DISPLAYING POTENTIAL DAMAGE TO COMPONENTS OF FREE LINES
PROCÉDÉ DE DÉTECTION ET DE REPRÉSENTATION DES ENDROITS ENDOMMAGÉS POTENTIELS SUR DES COMPOSANTS DES LIGNES AÉRIENNES

(30) Priorität: 27.06.2019 EP 19182926
(43) Veröffentlichungstag der Anmeldung: 16.03.2022
(73) Patentinhaber: Siemens Energy Global GmbH & Co. KG, 81739 München (DE)
(72) Erfinder: BIRCHBAUER, Josef Alois, 8054 Seiersberg (AT); HOBMAIER, Christoph, 1110 Wien (AT); HOCHSTÖGER, Simon, 1050 Wien (AT); KÄHLER, Olaf, 8052 Graz (AT); WAKOLBINGER, Stefan, 8010 Graz (AT)
(86) Internationale Anmeldenummer: PCT/EP2020/067304
(87) Internationale Veröffentlichungsnummer: WO 2020/260182

(56) Entgegenhaltungen:
- US-A1- 2012 262 708
- US-B1- 8 756 085
- US-B1- 9 129 355

## Beschreibung

Die Erfindung betrifft ein Verfahren zur Ermittlung und Darstellung von potenziellen Schadstellen an Komponenten von Freileitungen.

Elektrische Freileitungen, deren spannungsführende Leiter im Freien durch die Luft geführt und meist auch nur durch die umgebende Luft voneinander und vom Erdboden isoliert werden, werden beispielsweise als Hoch- und Mittelspannungs- sowie Bahnfahrleitungen eingesetzt.

Zur Vermeidung von Kurzschlüssen oder Leitungsunterbrechungen und ggf. daraus folgenden Stromunfällen müssen Freileitungen bestimmte Mindestabstände vom Erdboden, von Gebäuden, aber auch von der umgebenden Vegetation einhalten.

Um dies zu gewährleisten sind regelmäßige Inspektionen dieser Leitungen vorgeschrieben.

Aufgrund ihrer Abmessungen von vielen Kilometern Länge und einer Höhe von etwa 60 Metern ist die Überwachung dieser Freileitungen eine Aufgabe, die üblicherweise mittels Hubschraubern oder unbemannten Flugobjekten oder auch durch Begehung durchgeführt wird.

Beispielsweise US 9.129.355 B1 behandelt ein Verfahren und ein System zur Bewertung des Schadens an einer Infrastruktur unter Verwendung von Luftbildern, die von einem unbemannten Luftfahrzeug (UAV), einem bemannten Luftfahrzeug (MAV) oder von einem Satellitengerät aufgenommen wurden.

Dabei wird das betreffende Gelände in hindernisfreier Höhe überflogen und beispielsweise fotografiert und/oder mittels LiDAR gescannt und das Ergebnis als dreidimensionaler Datensatz festgehalten und ausgewertet.

Die Ergebnisse der Inspektionsvorgänge werden als Befunde festgehalten, aus denen in weiterer Folge Maßnahmen wie beispielsweise Reparaturen abgeleitet werden können.

Es ist bekannt, diese Befunde mit graphischen Darstellungen zu versehen, beispielsweise kann die Position schadhafter Komponenten wie eines Isolators an einem Mast durch ein Symbol wie einen Pfeil oder eine Markierung angezeigt werden.

Diese Visualisierung bzw. das Kenntlichmachen der Position des Befundes geschieht in der Regel manuell. Ebenso müssen die schematischen Zeichnungen der Masten entweder aus Plandaten abgeleitet, oder händisch erstellt werden.

Die Befliegung von Hochspannungstrassen oder anderen Anlagen mittels Laserscaneinrichtungen, und / oder Bildaufnahme mit anschließender visueller Kontrolle durch einen geschulten Techniker entspricht seit Jahren der gängigen Praxis.

Neben Aufnahmen im sichtbaren Bereich des Lichtes sind auch Aufnahmen im nahen Infrarotbereich oder mit thermischem Infrarot für bestimmte Anwendungsfälle vorteilhaft. So eignet sich nahes Infrarot mit einer Wellenlänge von 780 nm bis 3 µm (Spektralbereiche IR-A und IR-B) besonders gut zur Detektion von Vegetation, da im nahen Infrarotbereich Chlorophyll eine um etwa den Faktor 6 höhere Reflektivität als im sichtbaren Spektrum aufweist. Zur Erkennung von Vegetation kann dieser Effekt ausgenutzt werden, indem eine Aufnahme im vorzugsweise roten Spektrum des sichtbaren Bereichs, und eine weitere Aufnahme im nahen Infrarot gemacht wird. Nutzobjekte haben sowohl im sichtbaren als auch im nahen infraroten Bereich eine ungefähr gleiche Reflektivität, während Chlorophyll-haltige Vegetation im nahen Infrarot einen deutlich höheren Reflexionsgrad besitzt. Somit können z. B. auch grüne Nutzobjekte von ebenso grüner Vegetation unterschieden werden.

Mit Infrarot-Aufnahmen können aber auch thermische Defekte wie Heissstellen erkannt werden.

Zweckmäßig können auch Aufnahmen im ultravioletten Lichtbereich sein, da auf diesen beispielsweise Koronaeffekte/Teilentladungen besonders deutlich erkennbar sind.

Problematisch ist dabei der menschliche Faktor, d.h. es geschehen Fehler durch Unachtsamkeit beispielsweise aufgrund von Ermüdung oder Unerfahrenheit.

Der Erfindung liegt die Aufgabe zugrunde, die Visualisierung von Befunden zu automatisieren.

Erfindungsgemäß erfolgt die Lösung dieser Aufgabe mit dem Verfahren gemäß Anspruch 1.

Vorteilhafte Ausgestaltungen ergeben sich aus den Unteransprüchen.

Im Gegensatz zur manuellen Verortung von Befunden sieht die vorliegende Erfindung vor, den Befund vollautomatisch zu verorten und ebenso vollautomatisch eine geeignete Visualisierung zur einfachen Auffindung des Befundes für das Inspektionspersonal zu generieren.

Vorteilhaft ist es, wenn aus einem mittels Laserscaneinrichtung ermittelten Punktwolkendatensatz über die Freileitung und ihre Umgebung, der zu den einzelnen Punkten auch die exakte Position umfasst, Infrastrukturelemente der Freileitung wie Masten, und Komponenten wie Armaturen und Anbauelemente ermittelt und Darstellungen dieser Elemente auf erkennbare Schäden wie Brüche, Absplitterungen aber auch Fremdkörper wie Eisbehang oder Bewuchs analysiert.

Dazu werden vorzugsweise aus dem Stand der Technik bekannte Methoden des maschinellen Lernens (Künstliche Intelligenz) eingesetzt.

Wenn potenzielle Schadstellen solcherart ermittelt wurden, wird ihre Position festgehalten und in einer Darstellung des betroffenen Infrastrukturelementes beispielsweise mittels Pfeil oder Kreisringe angezeigt.

Diese Darstellungen ermöglichen es als Teil der Befunde dem Servicepersonal, Reparaturen effizient und zielgerichtet durchzuführen.

Die Erfindung wird anhand von Figuren näher erläutert. Es zeigen beispielhaft:

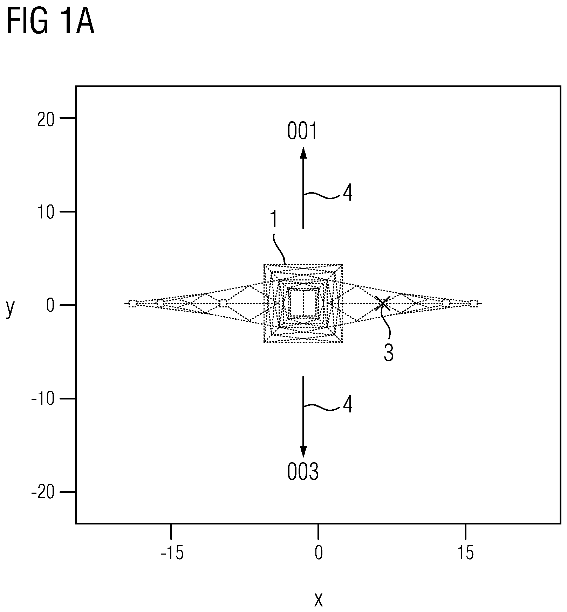

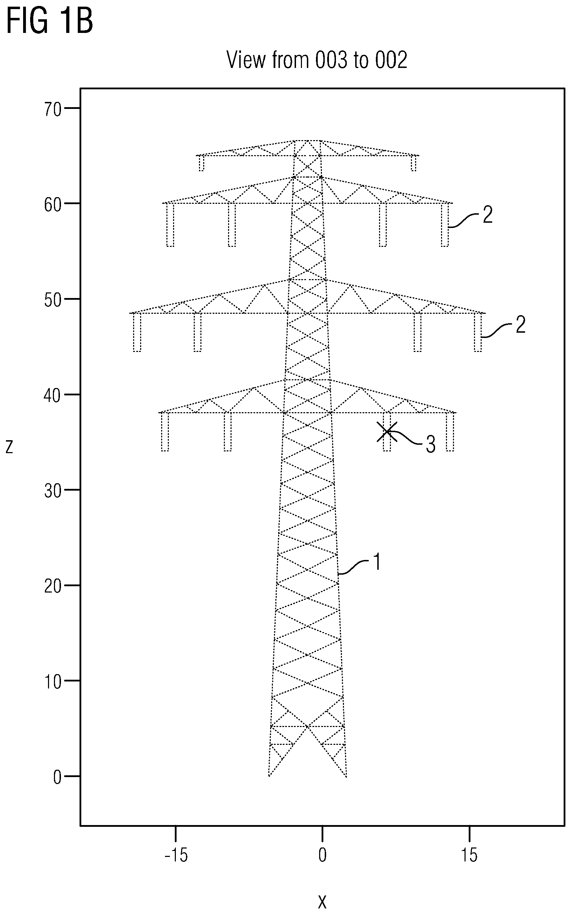

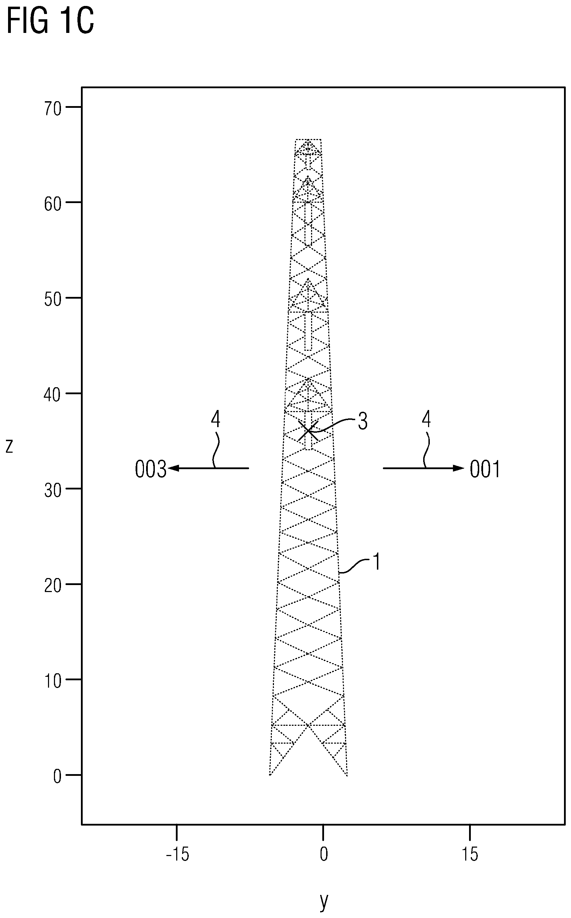

Fig. 1a, 1b, 1c und

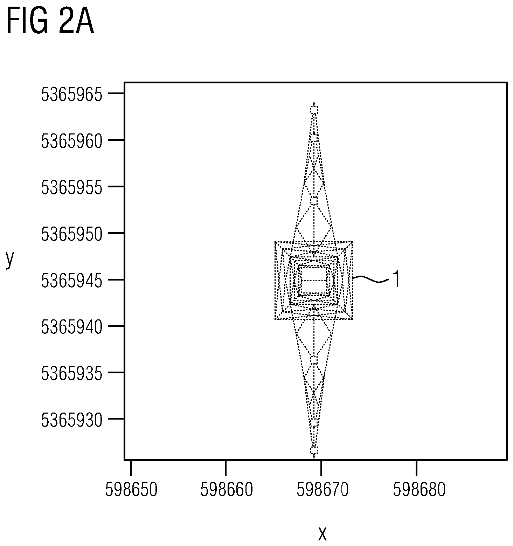

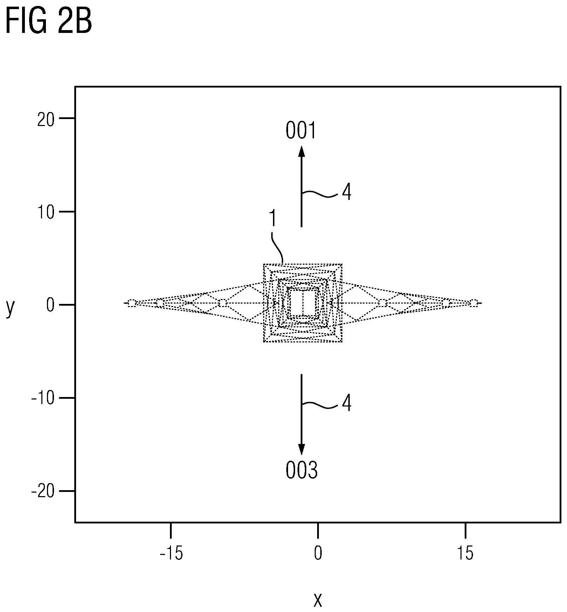

Fig. 2a, 2b Darstellungen von Masten einer Freileitung.

Die in den Figuren enthaltenen Darstellungen von Masten 1 einer Freileitung wurden aus mittels Laserscaneinrichtung (LIDAR) ermittelten Punktwolkendatensätzen zu diesen Masten abgeleitet.

Als LIDAR (light detection and ranging), wird ein dem Radar verwandtes Verfahren zur optischen Abstands- und Geschwindigkeitsmessung sowie zur Fernmessung atmosphärischer Parameter bezeichnet. Statt der Radiowellen wie beim Radar werden Laserstrahlen verwendet.

Beim Einsatz als Laserscanner werden Lichtimpulse ausgesendet, die von Objektpunkten reflektiert werden. Der Objektpunkt muss dabei mindestens aus einer Richtung einsehbar sein. Voraussetzung ist diffuse Reflexion an der Oberfläche. Die Technik funktioniert unabhängig von der Sonnenbeleuchtung und ermöglicht die Gewinnung von großen Mengen an 3D-Informationen über die Objekte bei sehr schnellen Aufnahmeraten.

Der Laser misst jeweils Abstandswerte des Scanners zu Objekten in der Umgebung, so dass sich aus einer Vielzahl von Messungen ein Punktwolkendatensatz ergibt. Ist die Position des Laserscanners bzw. des Trägerfahrzeugs, typischerweise eines Flugobjektes wie einer Drohne, einem Flächenflugzeug oder einem Hubschrauber bekannt, so kann die Position eines Punktes aus dem Punktwolkendatensatz durch Bezugnahme auf die Position der Laserscaneinrichtung bzw. des Flugobjekts und der Richtung, auf die die Laserscaneinrichtung ausgerichtet ist, sehr genau rekonstruiert werden. Bei dynamischen Messverfahren wie z.B. dem Mobile Laserscanning oder dem Airborne Laserscanning, werden Laserscanner, gemeinsam mit einem GNSS/INS-System (Global Navigation Satellite System bzw. Inertial Navigation System) eingesetzt.

Ist die relative Orientierung zwischen dem GNSS/INS-System und dem Laserscanner bekannt, kann durch Kombination der Fahrzeugtrajektorie und der Laserscanmessungen (Distanz und Richtungen) eine 3D-Punktwolke erzeugt werden.

Die einzelnen Punkte der 3D-Punktwolke bzw. des entsprechenden Punktwolkendatensatzes werden hinsichtlich ihrer Zugehörigkeit zu bestimmten Elementen der Freileitung und ihrer Umgebung klassifiziert, d.h. es wird festgestellt, ob der Punkt beispielsweise Teil eines Mastes 1, einer Leitung, oder eines Isolators 2 ist, bzw. ob er der Umgebung zugerechnet werden kann.

Dies erfolgt aufgrund des Verhältnisses des Punktes zu seiner Umgebung mit Methoden des maschinellen Lernens, bei denen die Klassenzuordnung der Punkte aus vorgegebenen Trainingsdaten zu typischen Mustern von Komponenten wie Isolatoren, Mastelementen etc. erlernt wird.

Diese erkannten Komponenten werden auf mögliche Schadstellen wie Brüche, Risse, Eis, Bewuchs untersucht und die Position der ermittelten potenziellen Schadstellen bzw. Fehlerquellen festgehalten.

Die Untersuchung der Komponenten auf Schadstellen bzw. auf Unversehrtheit erfolgt beim Ausführungsbeispiel auf Basis des Punktwolkendatensatzes, kann aber gleichermaßen auf davon abgeleiteten Darstellungen oder unabhängigen Informationen wie beispielsweise Sensordaten, Bildern, Beobachtungen etc. erfolgen.

Zu den daraus identifizierten Infrastrukturelementen, also beispielsweise dem Freileitungsmast, auf dem die Komponenten als sogenannte Armaturen oder Anbauten angeordnet sind, werden mit geeigneten Transformationen zweidimensionale standardisierte Ansichten wie Grund-, Auf- und Seitenriss abgeleitet.

Dabei ist es besonders vorteilhaft, wenn nur die identifizierten Infrastrukturelemente 1 und ihre unmittelbare Umgebung in eine zweidimensionale Ansicht transformiert werden und damit der Rechenaufwand geringgehalten wird und die Geschwindigkeit der Transformation erhöht werden kann. Erfindungsgemäß wird dabei die sogenannte Hauptkomponentenanalyse im Rahmen einer Hauptachsentransformation angewendet.

Die Hauptkomponentenanalyse, deren zugrunde liegendes mathematisches Verfahren auch als Hauptachsentransformation oder Singulärwertzerlegung bekannt ist, oder englisch Principal Component Analysis ist ein Verfahren der multivariaten Statistik. Sie dient dazu, umfangreiche Datensätze zu strukturieren, zu vereinfachen und zu veranschaulichen, indem eine Vielzahl statistischer Variablen durch eine geringere Zahl möglichst aussagekräftiger Linearkombinationen (die "Hauptkomponenten") genähert wird.

Erfindungsgemäß werden die zu einem Infrastrukturelement wie einem Masten 1 einmal ermittelten Transformationsparameter festgehalten und können dann in der Folge auf alle Armaturen und Anbauten dieses Infrastrukturelementes 1 wie beispielsweise Isolatoren 2 in gleicher Weise angewendet werden.

In einem Befund werden die Schadstellen 3 sowie die betroffenen Infrastrukturelemente 1 graphisch dargestellt, wobei die Position einer potenziellen Schadstelle 3 an einem Element beispielsweise mittels Pfeils oder Kreis angezeigt werden kann.

Diese graphische Darstellung kann überdies zusätzliche Orientierungsangaben 4 wie beispielsweise Himmelsrichtungen oder Hinweise auf die einer Darstellung zugrunde liegende Blickrichtung "Sicht von Mast 2 auf Mast 3" umfassen, um so das Auffinden der potentiellen Schadstellen weiter zu vereinfachen.

Im Ausführungsbeispiel wird die Freileitung mittels Laserscanner erfasst. Es ist aber auch möglich, mittels photogrammetrischer Verfahren dreidimensionale Repräsentationen aus zweidimensionalen Bildaufnahmen zu gewinnen und diese der weiteren Auswertung zugrunde zu legen.

### Bezugszeichenliste

- 1: Freileitungsmast
- 2: Isolator
- 3: potentielle Schadstelle
- 4: Orientierungsangaben

## Patentansprüche

1. Verfahren zur Ermittlung und Darstellung von potentiellen Schadstellen (3) an Komponenten (2) von Freileitungen mit folgenden Verfahrensschritten:
- die Freileitung und ihre Umgebung werden erfasst und eine dreidimensionale Repräsentation erstellt;
- Aus der dreidimensionalen Repräsentation werden relevante Komponenten (2) und Infrastrukturelemente (1) ermittelt
- Komponenten (2) und Infrastrukturelemente (1) werden auf Unversehrtheit untersucht;
- Bei Erkennung von potentiellen Schadstellen (3) wird die Position derselben ermittelt;
- Darstellungen der identifizierten Infrastrukturelemente (1) mit potentiellen Schadstellen (3) mit Positionsangaben werden für Servicepersonal erstellt,
**dadurch gekennzeichnet, dass** die Darstellungen der identifizierten Infrastrukturelemente (1) mittels Transformationsmatrix aus der dreidimensionalen Repräsentation abgeleitet werden,
dass die Parameter der Transformationsmatrix mittels Hauptachsentransformation bestimmt werden, und
dass zusätzliche Orientierungsangaben (4) aus den Parametern der Transformation generiert werden.

2. Verfahren nach Anspruch 1, **dadurch gekennzeichnet, dass**
- mittels Laserscaneinrichtung die Freileitung abgetastet wird;
- Aus der Position der Laserscaneinrichtung und ihrer Ausrichtung den Punkten des Punktwolkendatensatzes Positionen zugeordnet werden
- und als dreidimensionale Repräsentation ein dreidimensionaler Punktwolkendatensatz erstellt wird.

3. Verfahren nach Anspruch 2, **dadurch gekennzeichnet, dass** die Klassifizierung der Punkte hinsichtlich ihrer Zugehörigkeit zu bestimmten Infrastrukturelementen (1) mittels automatischem Klassifikationsverfahren erfolgt.

4. Verfahren nach Anspruch 3, **dadurch gekennzeichnet, dass** als automatisches Klassifikationsverfahren Methoden des maschinellen Lernens vorgesehen sind, bei denen die Klassenzuordnung der Punkte aus vorgegebenen Trainingsdaten erlernt wird.

5. Verfahren nach Anspruch 4, **dadurch gekennzeichnet, dass** die Darstellungen der identifizierten Infrastrukturelemente (1) standardisierte Ansichten wie Grund-, Auf- und Seitenriss umfassen.

6. Verfahren nach einem der Ansprüche 1 bis 5, **dadurch gekennzeichnet, dass** identifizierte potentielle Schadstellen (3) in den Darstellungen der jeweils betroffenen Infrastrukturelemente (1) mit Markierungen, insbesondere mit Pfeilen versehen werden.

7. Verfahren nach einem der Ansprüche 1 bis 6, **dadurch gekennzeichnet, dass** die Erfassung der Freileitung von einem Flugobjekt aus erfolgt.

## Claims

1. A method for determining and displaying potential damage (3) to components (2) of free lines, comprising the following method steps:
- logging the free line and its surroundings and creating a three-dimensional representation;
- determining relevant components (2) and infrastructure elements (1) from the three-dimensional representation
- examining components (2) and infrastructure elements (1) for integrity;
- upon detecting potential damage (3), determining the position thereof;
- creating displays of the identified infrastructure elements (1) with potential damage (3) including position information for service personnel,
**characterised in that** the displays of the identified infrastructure elements (1) are derived from the three-dimensional representation by means of a transformation matrix,
that the parameters of the transformation matrix are determined by means of main axis transformation, and
that additional orientation information (4) is generated from the parameters of the transformation.

2. The method according to claim 1, **characterised in that**
- the free line is scanned using a laser scanning device;
- positions are assigned to the points of the point cloud data set from the position of the laser scanning device and its alignment
- and a three-dimensional point cloud data set is created as a three-dimensional representation.

3. The method according to claim 2, **characterised in that** the points are classified with regard to their association with specific infrastructure elements (1) by means of an automatic classification method.

4. The method according to claim 3, **characterised in that** machine learning methods are provided as the automatic classification method, in which the classification of the points is learned from predetermined training data.

5. The method according to claim 4, **characterised in that** the displays of the identified infrastructure elements (1) comprise standardised views such as plan, top, and side views.

6. The method according to any one of claims 1 to 5, **characterised in that** identified potential damage (3) is provided with markings, in particular with arrows, in the displays of the respectively affected infrastructure elements (1).

7. The method according to any one of claims 1 to 6, **characterised in that** the free line is logged from a flying object.

## Revendications

1. Procédé pour la détermination et la représentation de zones endommagées potentielles (3) sur des composants (2) de lignes électriques aériennes, comprenant les étapes de procédé suivantes :
- l'acquisition de la ligne électrique aérienne et de son environnement et la création d'une représentation tridimensionnelle ;
- la détermination de composants (2) et d'éléments d'infrastructure (1) pertinents à partir de la représentation tridimensionnelle ;
- l'examen de l'intégrité des composants (2) et des éléments d'infrastructure (1) ;
- lors de la détection de zones endommagées potentielles (3), la détermination de la position de celles-ci ;
- la création de représentations des éléments d'infrastructure (1) identifiés présentant des zones endommagées potentielles (3) et pourvues d'indications de position pour le personnel de maintenance,
**caractérisé en ce que** les représentations des éléments d'infrastructure (1) identifiés soient dérivées de la représentation tridimensionnelle au moyen d'une matrice de transformation,
**en ce que** les paramètres de la matrice de transformation soient déterminés au moyen d'une transformation d'axes principaux, et
**en ce que** des indications d'orientation (4) supplémentaires soient générées à partir des paramètres de la transformation.

2. Procédé selon la revendication 1, **caractérisé en ce que** :
- la ligne électrique aérienne soit balayée au moyen d'un dispositif de balayage laser ;
- des positions soient attribuées aux points du jeu de données de nuage de points à partir de la position du dispositif de balayage laser et de son orientation ;
- et **en ce qu'**un jeu de données de nuage de points tridimensionnel soit créé en tant que représentation tridimensionnelle.

3. Procédé selon la revendication 2, **caractérisé en ce que** la classification des points quant à leur appartenance à des éléments d'infrastructure (1) spécifiques soit effectuée au moyen d'un procédé de classification automatique.

4. Procédé selon la revendication 3, **caractérisé en ce que** des méthodes d'apprentissage automatique soient prévues en tant que procédé de classification automatique, dans lequel l'attribution de classe des points est apprise à partir de données d'entraînement prédéfinies.

5. Procédé selon la revendication 4, **caractérisé en ce que** les représentations des éléments d'infrastructure (1) identifiés comprennent des vues standardisées telles qu'une vue en plan, une vue de face et une vue de profil.

6. Procédé selon l'une quelconque des revendications 1 à 5, **caractérisé en ce que** des zones endommagées potentielles (3) identifiées soient pourvues de marques, en particulier de flèches, dans les représentations des éléments d'infrastructure (1) respectivement concernés.

7. Procédé selon l'une quelconque des revendications 1 à 6, **caractérisé en ce que** l'acquisition de la ligne électrique aérienne soit effectuée à partir d'un aéronef.
